# EUROPEAN PATENT SPECIFICATION

(11) **EP 4 679 706 B1**
(45) Date of publication and mention of the grant of the patent: **07.10.2026**
(21) Application number: 25188053.0
(22) Date of filing: 08.07.2025
(51) Int. Cl.: H02M 7/487, G01R 19/175, G01R 29/16, G01R 31/42

(54) **NEUTRAL LINE DETECTION CIRCUIT AND METHOD**
NEUTRALLEITERDETEKTIONSSCHALTUNG UND -VERFAHREN
CIRCUIT ET PROCÉDÉ DE DÉTECTION DE LIGNE NEUTRE

(30) Priority: 10.07.2024 CN 202410925470
(43) Date of publication of application: 14.01.2026
(73) Proprietor: Delta Electronics (Shanghai) Co., Ltd., Shanghai 201209 (CN)
(72) Inventor: BAO, Licheng, Shanghai, 201209 (CN); FU, Chuanzhi, Shanghai, 201209 (CN); SHEN, Yixiang, Shanghai, 201209 (CN); JIN, Guangfeng, Shanghai, 201209 (CN); SUN, Jia, Shanghai, 201209 (CN); LIAO, Yongkai, Shanghai, 201209 (CN)
(74) Representative: SSM Sandmair

(56) References cited:
- CN-A- 103 326 332
- CN-A- 105 467 226

## Description

### BACKGROUND OF THE DISCLOSURE

### 1. Field of the Disclosure

The present disclosure relates to the field of power electronics, and particularly to a neutral line detection circuit and method.

### 2. Related Art

Three-phase power electronic converters (three-phase rectifiers, three-phase inverters, etc.) are widely applied worldwide. The control method of the three-phase power electronic converters is closely associated with the three-phase power grid structure, and generally, the three-phase power grid may be structurally divided into a three-phase three-wire power grid (without a neutral line) and a three-phase four-wire power grid (with a neutral line). In different power grid structures, the control methods of the three-phase power electronic converters are different, so the three-phase power electronic converters must distinguish the structure of the power grid, thereby adopting correct control ways.

Currently, the method of distinguishing the power grid structures is mainly to detect presence of the neutral line. In the prior art, the neutral line is often detected using the way of constructing asymmetric loads with additional resistors, but this method is not applicable to the three-phase power electronic converters, because: first, the additional equipment changes the circuit structure, and affects normal operation of the circuit; second, the resistors produce additional loss in the circuit, and reduce efficiency of the three-phase power electronic converters; third, the additional equipment increases design cost.

Therefore, it is necessary to develop a neutral line detection circuit and method to solve the problem faced in the prior art. It shall be noted that the information disclosed by the prior art is only to strengthen understanding of the background of the present disclosure, so information not constituting the prior art known to those skilled in the art may be included. Prior art can be found in document CN105467226A.

### SUMMARY OF THE DISCLOSURE

An object of the present disclosure is to provide a neutral line detection circuit and method, thereby determining presence or absence of a neutral line in the three-phase power grid conveniently and reliably.

In order to achieve the object, the present disclosure provides a neutral line detection circuit for a three-phase circuit having a load neutral point, the neutral line detection circuit including: three switches configured to be connected in series with respective phase branches of the three-phase circuit; three first capacitors connected between the load neutral point and first side nodes of the respective switches; three second capacitors connected between the load neutral point and second side nodes of the respective switches, respectively; a controller configured to execute: changing a state of the at least one switch to establish different load conditions; detecting parameter values of at least one load characteristic parameter under different load conditions; calculating a comparison value of the parameter values of the load characteristic parameter under different load conditions; determining whether the comparison value is within a specified threshold, if yes, determining presence of a neutral line; if no, determining absence of the neutral line.

In order to achieve the object, the present disclosure further provides a neutral line detection method applied to a three-phase circuit, wherein the three-phase circuit includes three switches connected in series with respective phase branches of the three-phase circuit, three first capacitors connected between a load neutral point of the three-phase circuit and first side nodes of the respective switches, and three second capacitors connected between the load neutral point and second side nodes of the respective switches, the neutral line detection method including: changing a state of the at least one switch to establish different load conditions; detecting parameter values of at least one load characteristic parameter under different load conditions; calculating a comparison value of the parameter values of the load characteristic parameter under different load conditions; determining whether the comparison value is within a specified threshold, if yes, determining presence of a neutral line; if no, determining absence of the neutral line.

Compared to the prior art, the neutral line detection circuit and method of the present disclosure has the following advantages:
Firstly, the present disclosure uses the capacitors as three-phase load impedances, which does not produce additional power loss, and may enhance efficiency of the circuit during operation.
Secondly, the three-phase load impedances of the present disclosure may be formed by X capacitors connected to the load neutral point through the respective phases in the EMI filter already configured in the circuit. This configuration does not produce additional influence in the circuit and reduces design cost.
Thirdly, the present disclosure is applicable to any power grid environment. It detects the neutral line based on the comparison value of the load characteristic parameter when the three-phase load transitions from symmetry to asymmetry or from asymmetry to another asymmetry. This method is independent of the three-phase power grid environment and is universally compatible with various grid configurations.

Additional aspects and advantages of the present disclosure will be in part set forth in the following description, and in part will be obvious from the description, or can be learned by practice of the present disclosure.

### BRIEF DESCRIPTION OF THE DRAWINGS

The exemplary embodiments will be described in details with reference to the accompanying drawings, through which the above, other features and advantages of the present disclosure will become more apparent.
FIG. 1 is a structural diagram of a neutral line detection circuit according to the present disclosure.
FIG. 2 is a flow diagram of a neutral line detection method according to the present disclosure.
FIG. 3A is a simplified diagram of the neutral line detection circuit of FIG. 1 in a three-phase four-wire power grid.
FIG. 3B is a simplified diagram of the neutral line detection circuit of FIG. 1 in a three-phase three-wire power grid.
FIG. 4 is a specific flow diagram of a neutral line detection method in one preferable embodiment of the present disclosure.
FIG. 5 is a result diagram of simulation under conditions of the three-phase three-wire power grid in one typical embodiment of the present disclosure.
FIG. 6 is a result diagram of simulation under conditions of the three-phase four-wire power grid in one typical embodiment of the present disclosure.

### DETAILED EMBODIMENTS OF THE DISCLOSURE

The example embodiments will now be described more fully with reference to the accompanying drawings. The example embodiments can, however, be implemented in various forms, and should not be construed as being limited to the embodiments set forth herein; rather, these embodiments are provided so that the present disclosure will be thorough and complete, and will fully convey the concept of the example embodiments to those skilled in the art. In the drawings, the same reference numerals denote the same or similar structure, thus their detailed description will be omitted.

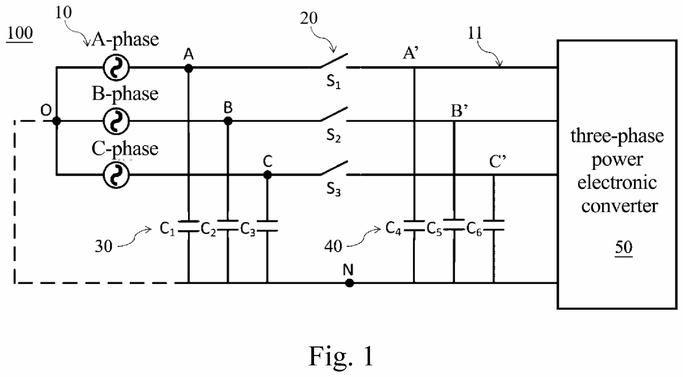

As shown in FIG. 1, the present disclosure provides a neutral line detection circuit 100, which includes three switches 20, three first capacitors 30, three second capacitors 40 and a controller (not shown).

The three switches 20 are connected in series with respective phase branches 11 of a three-phase circuit 10, and for example, the three switches 20 includes a switch S₁ connected in series with an A-phase branch, a switch S₂ connected in series with a B-phase branch and a switch S₃ connected in series with a C-phase branch. To facilitate explanation, in the present disclosure, one side of the switch connected to the power grid is defined as a first side of the switch, and the other side of the switch is defined as a second side of the switch. In the present disclosure, the form of the switch 20 includes but not limited to a relay, a power semiconductor switch, or the like.

The three first capacitors 30 are connected between a load neutral point N of the three-phase circuit 10 and first side nodes (i.e., nodes A, B and C) of the respective switches 20.For example, the three first capacitors 30 include a capacitor C₁ connected between the load neutral point N and the node A, a capacitor C₂ connected between the load neutral point N and the node B and a capacitor C₃ connected between the load neutral point N and the node C.

The three second capacitors 40 are connected between the load neutral point N and second side nodes (i.e., nodes A', B' and C') of the respective switches 20. For example, the three second capacitors 40 include a capacitor C₄ connected between the load neutral point N (hereinafter sometimes referred to as "node N") and the node A', a capacitor C₅ connected between the load neutral point N and the node B' and a capacitor C₆ connected between the load neutral point N and the node C'.

The controller (not shown) is configured to execute: changing a state of the at least one switch to establish different load conditions; detecting parameter values of at least one load characteristic parameter under different load conditions; calculating a comparison value of the parameter values of the load characteristic parameter under different load conditions; determining whether the comparison value is within a specified threshold, if yes, determining presence of a neutral line; if no, determining absence of the neutral line.

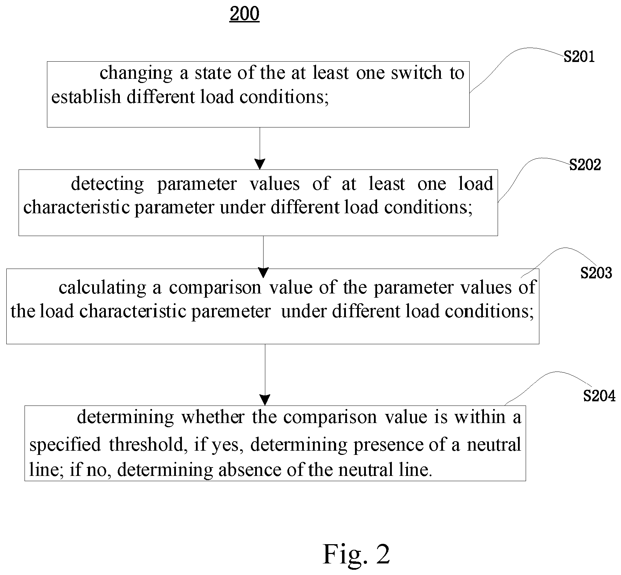

As shown in FIG. 2, a neutral line detection method 200 provided in the present disclosure may be applied to the three-phase circuit 10 shown in FIG. 1. The neutral line detection method 200 of the present disclosure includes the steps of:
Step S201: changing a state of the at least one switch to establish different load conditions;
Step S202: detecting parameter values of at least one load characteristic parameter under different load conditions;
Step S203: calculating a comparison value of the parameter values of the load characteristic parameter under different load conditions;
Step S204: determining whether the comparison value is within a specified threshold, if yes, determining presence of a neutral line; if no, determining absence of the neutral line.

The neutral line detection method 200 of the present disclosure may be executed by the controller.

Continuing to refer to FIG. 1, in some embodiments of the present disclosure, capacitances of the three first capacitors 30 (i.e., the capacitors C₁, C₂ and C₃) are equal, and capacitances of the three second capacitors 40 (i.e., the capacitors C₄, C₅ and C₆) are not equal (i.e., the capacitance of at least one of the capacitors C₄, C₅ and C₆ is not equal to the capacitances of other capacitors). Changing a state of the at least one switch to establish different load conditions includes: turning off the three switches 20 (i.e., the switches S₁, S₂ and S₃) to establish a three-phase symmetric load condition; turning on the at least one switch 20 (i.e., at least one of the switches S₁, S₂ and S₃) to establish a three-phase asymmetric load condition. Specifically, when the switches S₁, S₂ and S₃ are all turned off, the capacitors C₁, C₂ and C₃ and the three-phase power grid form a current loop. Since the capacitances of the capacitors C₁, C₂ and C₃ are equal, the load of the three-phase circuit is a three-phase symmetric load. When at least one of the switches S₁, S₂ and S₃ is turned on, for example, the switch S₁ is turned on, and S₂ and S₃ are turned off, the capacitor C₄ is connected in parallel with the capacitor C₁. Obviously, the capacitance of the total capacitors after the capacitor C₄ is connected in parallel with the capacitor C₁ is not equal to the capacitance of the capacitor C₂ (or C₃).Thereby, the load of the three-phase circuit is changed to a three-phase asymmetric load.

Continuing to refer to FIG. 1, in other embodiments of the present disclosure, capacitances of the three first capacitors 30 (i.e., the capacitors C₁, C₂ and C₃) are equal, and capacitances of the three second capacitors 40 (i.e., the capacitors C₄, C₅ and C₆) are equal. Changing a state of the at least one switch to establish different load conditions includes: turning off the three switches 20 (i.e., the switches S₁, S₂ and S₃) or turning on the three switches 20 (i.e., the switches S₁, S₂ and S₃) to establish a three-phase symmetric load condition; and turning on one or two switches 20 (i.e., one or two of the switches S₁, S₂ and S₃) to establish a three-phase asymmetric load condition. Specifically, when the switches S₁, S₂ and S₃ are all turned off, the capacitors C₁, C₂ and C₃ and the three-phase power grid form a current loop. Since the capacitances of the capacitors C₁, C₂ and C₃ are equal, the load of the three-phase circuit is a three-phase symmetric load. When the switches S₁, S₂ and S₃ are all turned on, the capacitor C₁ is connected in parallel with the capacitor C₄, the capacitor C₂ is connected in parallel with the capacitor C₅, and the capacitor C₃ is connected in parallel with the capacitor C₆. Since the capacitances of the capacitors C₁, C₂ and C₃ are equal, and the capacitances of the capacitors C₄, C₅ and C₆ are equal, the load of the three-phase circuit is still the three-phase symmetric load. When one or two of the switches S₁, S₂ and S₃ are turned on, for example, the switch S₁ is turned on, and S₂ and S₃ are turned off, the capacitor C₄ is connected in parallel with the capacitor C₁. Obviously, the capacitance of the total capacitors after the capacitor C₄ is connected in parallel with the capacitor C₁ is not equal to the capacitance of the capacitor C₂ (or C₃).Thereby, the load of the three-phase circuit is changed to a three-phase asymmetric load.

Continuing to refer to FIG. 1, in other embodiments of the present disclosure, capacitances of the three first capacitors 30 (i.e., the capacitors C₁, C₂ and C₃) are not equal, and changing a state of the at least one switch to establish different load conditions includes: turning on the at least one switch 20 (i.e., the switch S₁ or S₂ or S₃) such that the load condition is changed from the first three-phase asymmetric load condition to the second three-phase asymmetric load condition (i.e., change from a three-phase asymmetric load condition to another three-phase asymmetric load condition). Specifically, when the capacitances of the capacitors C₁, C₂ and C₃ are within a certain range, if the switches S₁, S₂ and S₃ are all turned off, the capacitors C₁, C₂ and C₃ and the three-phase power grid form a current loop. Since the capacitances of the capacitors C₁, C₂ and C₃ are not equal, the load of the three-phase circuit is a first three-phase asymmetric load. When the switch S₁ is turned on, and the switches S₂ and S₃ remain off state, the capacitor C₁ is connected in parallel with the capacitor C₄. Since the three-phase load changes, the three-phase load is changed from the first three-phase asymmetric load to the second three-phase asymmetric load.

In the present disclosure, calculating a comparison value of the parameter values of the load characteristic parameter under different load conditions may include: calculating the comparison value of the parameter values of the load characteristic parameter under different load conditions through a subtracting or dividing method. In some embodiments, the load characteristic parameter, for example, may include a load phase voltage. For example, the parameter values of the load phase voltage of the phase branch where the state of the switch is toggled between on and off may be a first voltage V1 and a second voltage V2, respectively, wherein the parameter value of the load phase voltage may be an effective value or maximum value of the load phase voltage. For example, in the three switches S₁, S₂ and S₃, the switches S₂ and S₃ remain off state, the switch S₁ is firstly turned on and then turned off. When the switch S₁ is turned on, the parameter value of the load phase voltage of the A-phase branch may be defined as the first voltage V1, and when the switch S₁ is turned off, the parameter value of the load phase voltage of the A-phase branch may be defined as the second voltage V2.

When calculating the comparison value of the parameter values through the subtracting method, the specified threshold may be defined as a*V1. When the condition | V1-V2 | > a*V1 is satisfied, absence of the neutral line may be determined, and the corresponding three-phase power grid is a three-phase three-wire system; in contrast, presence of the neutral line may be determined, and the corresponding power grid is a three-phase four-wire system. In some embodiments, the value a may be set according to actual requirements, for example, a=0.1, but the present disclosure is not limited thereto.

When calculating the comparison value of the parameter values through the dividing method, the specified threshold may be defined as b. When the condition V1/V2 > b is satisfied, absence of the neutral line may be determined, and the corresponding three-phase power grid is a three-phase three-wire system; in contrast, presence of the neutral line may be determined, and the corresponding power grid is a three-phase four-wire system. In some embodiments, the value b may be set according to actual requirements, for example, b=1.2, but the present disclosure is not limited thereto.

Continuing to refer to FIG. 1, in some embodiments of the present disclosure, the neutral line detection circuit 100 of the present disclosure may further include a three-phase power electronic converter 50 electrically connected to the three phase branches 11 of the three-phase circuit 10, wherein an EMI filter (not shown) is configured in the three-phase circuit (10). As a typical embodiment, the three first capacitors 30 (i.e., the capacitors C₁, C₂ and C₃) and/or the three second capacitors 40 (i.e., the capacitors C₄, C₅ and C₆) may be X capacitors of the EMI filter, each electrically connected to the load neutral point N in the respective phase branches. Generally, the three-phase circuit has electromagnetic interference (EMI) including common-mode interference and differential-mode interference. In order to suppress the EMI, an EMI filter must be set in the three-phase circuit, wherein, the X capacitors are mainly to suppress differential-mode interference, and are usually connected between the load neutral point and the phase branch inside the EMI filter. In such way, the X capacitors in the existing EMI filter of the three-phase circuit may be used to detect presence or absence of a neutral line without additional elements, thereby not producing additional power loss and enhancing operation efficiency of the three-phase circuit.

Hereinafter taking one typical embodiment of the neutral line detection circuit shown in FIG. 1 for example, the neutral line detection method and its basic principle of the present disclosure are explained in details with reference to FIG. 1. In this embodiment, the neutral line detection circuit 100 includes three switches S₁, S₂ and S₃, three first capacitors C₁, C₂ and C₃ and three second capacitors C₄, C₅ and C₆. Moreover, the capacitances of the first capacitors C₁, C₂ and C₃ are equal, and the capacitances of the second capacitors C₄, C₅ and C₆ are equal.

When the power grid structure is a three-phase four-wire system, a power grid neutral point O and the load neutral point N are connected through a neutral line, i.e., there is a neutral line. When the power grid structure is a three-phase three-wire system, the power grid neutral point O and the load neutral point N are not connected, i.e., there is no neutral line.

Since the power grid phase voltage cannot be directly measured from the power grid neutral point O in actual operating conditions, the present disclosure employs a method for detecting a load phase voltage to determine presence or absence of the neutral line.

The basic principle of the neutral line detection method of the present disclosure is as follows:

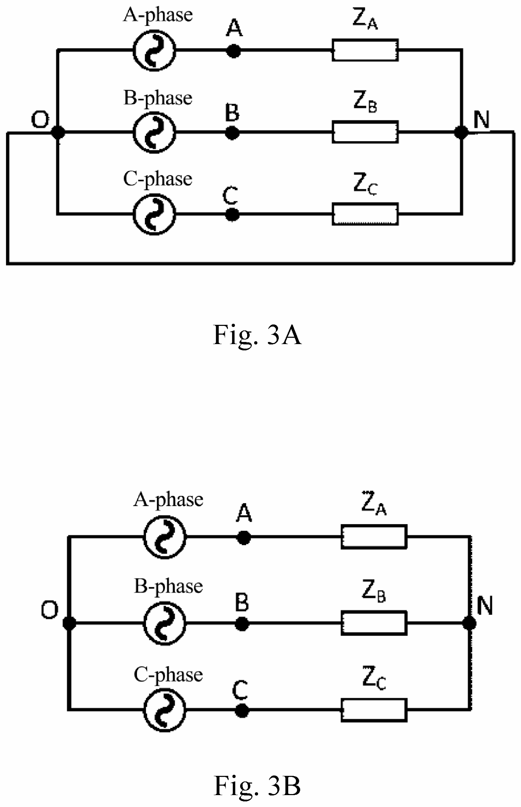

In the three-phase four-wire power grid, the neutral line detection circuit of FIG. 1 may be simplified to FIG. 3A, and Z_{A}, Z_{B} and Z_{C} in FIG. 3A represent impedances of the A-phase, B-phase and C-phase branches, respectively. The neutral line connects the power grid neutral point O and the load neutral point N, and a potential V_{NO} of the load neutral point satisfies:
${V}_{NO} = 0$

That is, the potential V_{NO} of the load neutral point is remains constant, and regardless of the three-phase load impedances variation, the load phase voltages V_{AN}, V_{BN} and V_{CN} are remain equal to the power grid phase voltages, i.e., the load phase voltages V_{AN}, V_{BN} and V_{CN} remain constant.

In the three-phase three-wire power grid, the neutral line detection circuit of FIG. 1 may be simplified to FIG. 3B, and Z_{A}, Z_{B} and Z_{C} in FIG. 3B represent impedances of the A-phase, B-phase and C-phase branches, respectively. According to the circuit theory, a potential V_{NO} of the load neutral point satisfies:
${V}_{NO} = \frac{\frac{{V}_{AO}}{{Z}_{A}} + \frac{{V}_{BO}}{{Z}_{B}} + \frac{{V}_{CO}}{{Z}_{C}}}{\frac{1}{{Z}_{A}} + \frac{1}{{Z}_{B}} + \frac{1}{{Z}_{C}}}$

That is, the potential V_{NO} of the load neutral point depends on the three-phase load impedances. When the three-phase load transitions from symmetry to asymmetry conditions, the load phase voltages V_{AN}, V_{BN} and V_{CN} change accordingly.

Meanwhile, the basic principle is independent of the specific power grid environment, i.e., the basic principle is applicable in any power grid environment.

Based on the basic principle, the neutral line detection method of the present disclosure includes the following steps: Prior to initiating the three-phase power electronic converter, firstly, detecting the load phase voltage under the three-phase symmetric load condition; then, detecting the load phase voltage under the three-phase asymmetric load condition; finally, comparing the two sets of load phase voltages, and:
if the comparison value of the two sets of load phase voltages is within the specified threshold, determining presence of a neutral line, thereby identifying the power grid structure is a three-phase four-wire system;
if the comparison value exceeds the specified threshold, determining absence of the neutral line, thereby identifying the power grid structure is a three-phase three-wire system.

The present disclosure proposes a design concept in which the converter is configured to transition between the three-phase symmetric load condition and the three-phase asymmetric load condition, thereby detecting presence or absence of the neutral line. Similarly, the converter can also transition between a three-phase asymmetric load condition to another three-phase asymmetric load condition, thereby determining presence or absence of the neutral line.

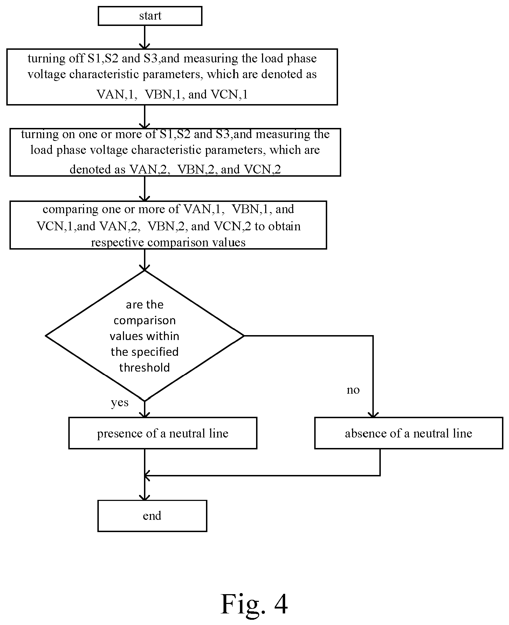

Hereinafter specific process of the neutral line detection method of the present disclosure is set forth in details with reference to FIGS. 1 and 4:
Initially, the three-phase power electronic converter is not started, and the switches S₁, S₂ and S₃ are turned off. At this stage, the three-phase load in the circuit is symmetrical. The parameter values of the load characteristic parameter (e.g., the load phase voltage characteristic parameter) are measured, wherein, the parameter values include but not limited to the maximum value, the effective value and the like of the load phase voltage. The load phase voltages between nodes A, B, C and the neutral point N are V_{AN,1}, V_{BN,1} and V_{CN,1}, respectively.

Next, the asymmetric three-phase load is established by turning on one or more of the switches S₁, S₂ and S₃. The switch combination is f(S₁,S₂,S₃) , where six valid configurations exist (excluding cases where all switches are on or all are off). Subsequently, the load phase voltages are measured. At this stage, the load phase voltage between nodes A, B, C and the neutral point N are denoted as V_{AN,2}, V_{BN,2} and V_{CN,2}, respectively.

Finally, with the switch combination set to f(S₁,S₂,S₃), one or more pairs the load phase voltages V_{AN,1} and V_{AN,2}, V_{BN,1} and V_{BN,2}, V_{CN,1} and V_{CN,2} are compared (the comparison method includes but not limited to subtraction or division, etc.). If a comparison value between the two measured parameter values falls within the specified threshold, presence of a neutral line is determined, thereby identifying the power grid as a three-phase four-wire system; in contrast, absence of the neutral line is determined, thereby identifying the power grid as a three-phase three-wire system.

As a typical specific embodiment of the present disclosure, in order to balance the three phases of the power grid, the capacitances of the first capacitors C₁, C₂ and C₃ and the second capacitors C₄, C₅ and C₆ are all equal, and the switch combination f(S₁,S₂,S₃) is that S₁ is turned on, and S₂ and S₃ are turned off, taking the load characteristic parameter as the load phase voltage and the effective values V_{AN,1} and V_{AN,2} for example:

In the case of the three-phase four-wire system, before S₁ is turned on, V_{AN,1} is an effective value V_{A} of an A-phase power grid voltage; after S₁ is turned on, since the potential of the load neutral point is substantially constant, V_{AN,2} is approximately the effective value V_{A} of the A-phase power grid voltage.

In the case of the three-phase three-wire system, before S₁ is turned on, V_{AN,1} is the A-phase power grid voltage V_{A}; after S₁ is turned on, since the potential of the load neutral point changes, according to the relational expression of the potential V_{NO} of the load neutral point of the three-phase three-wire system, it may be calculated that V_{AN,2} is 0.75 times of the A-phase power grid voltage, i.e., V_{AN,2}=0.75V_{AN,1}=0.75V_{A}.

Accordingly, when the dividing method is used, the specified threshold may be set to be 1.2 (i.e., b=1.2), and if V_{AN,1}/V_{AN,2} is greater than 1.2, the power grid is determined to be the three-phase three-wire power grid; otherwise, the power grid is determined to be the three-phase four-wire power grid. When the subtracting method is used, as for the three-phase four-wire power grid, an absolute value | V_{AN,1}- V_{AN,2} | of the difference between V_{AN,1} and V_{AN,2} is approximately 0, and as for the three-phase three-wire power grid, an absolute value | V_{AN,1}- V_{AN,2} | of the difference between V_{AN,1} and V_{AN,2} is approximately 0.25V_{A}. The specified threshold under the subtracting method may be set to be 0.1V_{A} (i.e., a=0.1), and if the absolute value | V_{AN,1}- V_{AN,2} | of the difference between V_{AN,1} and V_{AN,2} is greater than 0.1V_{A}, the power grid is determined to be the three-phase three-wire power grid ; otherwise, the power grid is determined to be the three-phase four-wire power grid.

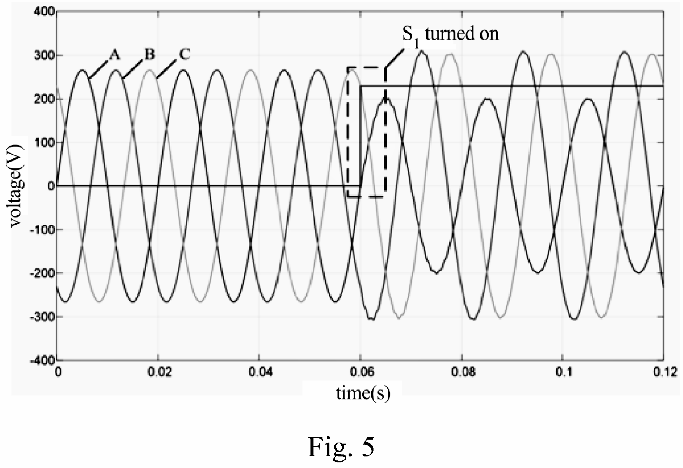

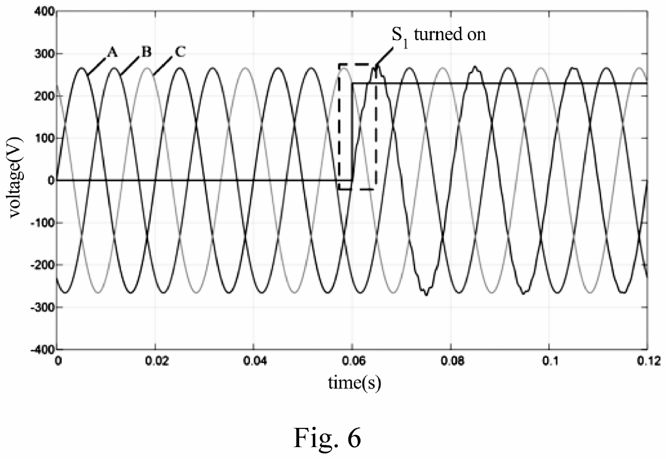

To validate feasibility of the neutral line detection method of the present disclosure, the typical embodiment performs simulation in both the three-phase three-wire power grid and the three-phase four-wire power grid scenarios. The simulation results are shown in FIGS. 5 and 6. FIG. 5 illustrates the simulation outcome for the three-phase three-wire power grid in one embodiment of the present disclosure. As shown in FIG. 5, in the case of the three-phase three-wire power grid, after S₁ activation, the load phase voltages of the A-phase, B-phase and C-phase branches all differ significantly from their pre-activation values, and V_{AN,1}/V_{AN,2} is approximately 1.33 (which is greater than the specified threshold 1.2). FIG. 6 illustrates the simulation outcome for the three-phase four-wire power grid in one embodiment of the present disclosure. As shown in FIG. 6, in the case of the three-phase four-wire power grid, after S₁ is turned on, the load phase voltages of the A-phase, B-phase and C-phase branches remain the load phase voltages before S₁ is turned on, and V_{AN,1}/V_{AN,2} is approximately 1 (which is less than the specified threshold 1.2). Accordingly, presence or absence of the neutral line may be determined by comparing whether V_{AN,1}/V_{AN,2} is greater than the specified threshold 1.2 before and after S₁ is turned on. The simulation results shown in FIGS. 5 and 6 validate feasibility of the neutral line detection method of the present disclosure.

Obviously, the neutral line detection method of the present disclosure herein determines presence or absence of the neutral line according to the comparison value of the load phase voltages (before and after switch state changes) with the specified threshold. Specifically, no matter whether the three first capacitors are equal. Upon switching the switch state, the load impedances of the corresponding phase branches vary. If the three-phase circuit includes a neutral line, the potential of the load neutral point remains independent of the load impedance, and the corresponding comparison value is within the specified threshold; if the three-phase circuit does not include a neutral line, the potential of the load neutral point is dependent on the load impedance, and after the switch state changes, the potential of the corresponding load neutral point changes accordingly, and the load phase voltage also changes, such that the corresponding comparison value exceeds the specified threshold.

As compared to the prior art, the neutral line detection circuit and method of the present disclosure have the following advantages:
Firstly, the present disclosure uses the capacitors as three-phase load impedances, which does not produce additional power loss, and may enhance efficiency of the circuit during operation. According to the formula of impedance of the capacitor:
$Z = \frac{1}{jwC}$

Due to the low operating frequency of the power grid, the impedance of the capacitor is very large, which minimizes additional power loss in the circuit and may enhance efficiency of the circuit during operation.

Secondly, the three-phase load impedances of the present disclosure may be formed by X capacitors connected to the load neutral point through the respective phases in the EMI filter already configured in the circuit. This configuration does not produce additional influence in the circuit and reduces design costs.

Thirdly, the present disclosure is applicable to any power grid environment. It detects the neutral line based on the comparison value of the load characteristic parameter when the three-phase load transitions from symmetry to asymmetry or from asymmetry to another asymmetry. This method is independent of the three-phase power grid environment and is universally compatible with various grid configurations.

The above exemplary embodiments of the present disclosure are illustrated and described in details. It should be understood that the present disclosure is not limited to the disclosed embodiments, rather, the present disclosure intends to cover various modifications and equivalent arrangements included in the spirit and scope of the appended claims.

## Claims

1. A neutral line detection circuit (100) for a three-phase circuit (10) having a load neutral point (N), the neutral line detection circuit (100) comprising
three switches (20: S₁, S₂, S₃) configured to be connected in series with respective phase branches (11) of the three-phase circuit (10);
three first capacitors (30: C₁, C₂, C₃) connected between the load neutral point (N) and first side nodes (A, B, C) of the respective switches (20: S₁, S₂, S₃);
three second capacitors (40: C₄, C₅, C₆) connected between the load neutral point (N) and three second side nodes (A', B', C') of the respective switches (20: S₁, S₂, S₃);
a controller configured to execute:
changing a state of the at least one switch to establish different load conditions;
detecting parameter values of at least one load characteristic parameter under different load conditions;
**characterized by** the controller further configured to execute:
calculating a comparison value of the parameter values of the load characteristic parameter under different load conditions;
determining whether the comparison value is within a specified threshold, if yes, determining presence of a neutral line; if no, determining absence of the neutral line.

2. The neutral line detection circuit (100) according to claim 1, wherein capacitances of the three first capacitors (30: C₁, C₂, C₃) are equal, capacitances of the three second capacitors (40: C₄, C₅, C₆) are not equal, and changing a state of the at least one switch to establish different load conditions comprises:
turning off the three switches (20: S₁, S₂, S₃) to establish a three-phase symmetric load condition; and
turning on the at least one switch to establish a three-phase asymmetric load condition.

3. The neutral line detection circuit (100) according to claim 1, wherein capacitances of the three first capacitors (30: C₁, C₂, C₃) are equal, capacitances of the three second capacitors (40: C₄, C₅, C₆) are equal, and changing a state of the at least one switch to establish different load conditions comprises:
turning off the three switches (20: S₁, S₂, S₃) or turning on the three switches (20: S₁, S₂, S₃) to establish a three-phase symmetric load condition; and
turning on one or two switches to establish a three-phase asymmetric load condition.

4. The neutral line detection circuit (100) according to claim 1, wherein capacitances of the three first capacitors (30: C₁, C₂, C₃) are not equal, and changing a state of the at least one switch to establish different load conditions comprises:
turning on the at least one switch such that the load condition is changed from the first three-phase asymmetric load condition to the second three-phase asymmetric load condition.

5. The neutral line detection circuit (100) according to any of claims 2 to 4, wherein calculating a comparison value of the parameter values of the load characteristic parameter under different load conditions comprises:
calculating the comparison value through a subtracting or dividing method.

6. The neutral line detection circuit (100) according to claim 5, wherein the load characteristic parameter comprises a load phase voltage, the parameter values of the load phase voltage of the phase branch on which the state of the switch is toggled between on and off are a first voltage V1 and a second voltage V2, respectively, when calculating the comparison value of the parameter values through the subtracting method, the specified threshold is defined as a*V1, and when the condition |V1-V2| > a*V1 is satisfied, absence of the neutral line is determined; otherwise, presence of the neutral line is determined.

7. The neutral line detection circuit (100) according to claim 5, wherein the load characteristic parameter comprises a load phase voltage, the parameter values of the load phase voltage of the phase branch on which the state of the switch is toggled between on and off are a first voltage V1 and a second voltage V2, respectively, when calculating the comparison value of the parameter values through the dividing method, the specified threshold is defined as b, and when the condition V1/V2 > b is satisfied, absence of the neutral line is determined; otherwise, presence of the neutral line is determined.

8. The neutral line detection circuit (100) according to claim 1, wherein the neutral line detection circuit further comprises:
a three-phase power electronic converter (50) electrically connected to the three phase branches (11) of the three-phase circuit (10), wherein an EMI filter is configured in the three-phase circuit (10), and the three first capacitors (30: C₁, C₂, C₃) and the three second capacitors (40: C₄, C₅, C₆) are X capacitors of the EMI filter, each electrically connected to the load neutral point (N) in the respective phase branches (11).

9. A neutral line detection method (200) applied to a three-phase circuit (10), wherein the three-phase circuit (10) comprises three switches (20: S₁, S₂, S₃) connected in series with respective phase branches (11) of the three-phase circuit (10), three first capacitors (30: C₁, C₂, C₃) connected between a load neutral point (N) of the three-phase circuit (10) and first side nodes (A, B, C) of the connected switches (20: S₁, S₂, S₃), and three second capacitors (40: C₄, Cs, C₆) connected between the load neutral point (N) and second side nodes (A', B', C') of the respective switches (20: S₁, S₂, S₃), whereby the neutral line detection method comprises:
changing a state of the at least one switch to establish different load conditions;
detecting parameter values of at least one load characteristic parameter under different load conditions;
**characterized in that** the method further comprises:
calculating a comparison value of the parameter values of the load characteristic parameter under different load conditions;
determining whether the comparison value is within a specified threshold, if yes, determining presence of a neutral line; if no, determining absence of the neutral line.

10. The neutral line detection method (200) according to claim 9, wherein capacitances of the three first capacitors (30: C₁, C₂, C₃) are equal, capacitances of the three second capacitors (40: C₄, C₅, C₆) are not equal, and changing a state of the at least one switch to establish different load conditions comprises:
turning off the three switches to establish a three-phase symmetric load condition; and
turning on the at least one switch to establish a three-phase asymmetric load condition.

11. The neutral line detection method (200) according to claim 9, wherein capacitances of the three first capacitors (30: C₁, C₂, C₃) are equal, capacitances of the three second capacitors (40: C₄, C₅, C₆) are equal, and changing a state of the at least one switch to establish different load conditions comprises:
turning off the three switches or turning on the three switches to establish a three-phase symmetric load condition; and
turning on one or two switches to establish a three-phase asymmetric load condition.

12. The neutral line detection method (200) according to claim 9, wherein capacitances of the three first capacitors (30: C₁, C₂, C₃) are not equal, and changing a state of the at least one switch to establish different load conditions comprises:
turning on the at least one switch such that the load condition is changed from the first three-phase asymmetric load condition to the second three-phase asymmetric load condition.

13. The neutral line detection method (200) according to any of claims 10 to 12, wherein calculating a comparison value of the parameter values of the load characteristic parameter under different load conditions comprises:
calculating the comparison value through a subtracting or dividing method.

14. The neutral line detection method (200) according to claim 13, wherein the load characteristic parameter comprises a load phase voltage, the parameter values of the load phase voltage of the phase branch on which the state of the switch is toggled between on and off are a first voltage V1 and a second voltage V2, respectively, when calculating the comparison value of the parameter values through the subtracting method, the specified threshold is defined as a*V1, and when the condition | V1-V2 | > a*V1 is satisfied, absence of the neutral line is determined; otherwise, presence of the neutral line is determined.

15. The neutral line detection method (200) according to claim 13, wherein the load characteristic parameter comprises a load phase voltage, the parameter values of the load phase voltage of the phase branch on which the state of the switch is toggled between on and off are a first voltage V1 and a second voltage V2, respectively, when calculating the comparison value of the parameter values through the dividing method, the specified threshold is defined as b, and when the condition V1/V2 > b is satisfied, absence of the neutral line is determined; otherwise, or presence of the neutral line is determined.

## Patentansprüche

1. Eine Neutralleiterdetektionsschaltung (100) für einen Dreiphasenschaltkreis (10) mit einem Lastneutralpunkt (N), wobei die Neutralleiterdetektionsschaltung (100) umfasst:
drei Schalter (20: S₁, S₂, S₃), die dazu eingerichtet sind, jeweils in Reihe mit den entsprechenden Phasenzweigen (11) des Dreiphasenschaltkreises (10) verbunden zu werden;
drei erste Kondensatoren (30: C₁, C₂, C₃), die zwischen dem Lastneutralpunkt (N) und erstseitigen Knoten (A, B, C) der jeweiligen Schalter (20: S₁, S₂, S₃) verbunden sind;
drei zweite Kondensatoren (40: C₄, C₅, C₆), die zwischen dem Lastneutralpunkt (N) und drei zweitseitigen Knoten (A', B', C') der jeweiligen Schalter (20: S₁, S₂, S₃) verbunden sind;
eine Steuerung, die dazu eingerichtet ist, Folgendes auszuführen:
Ändern eines Zustands des mindestens einen Schalters, um unterschiedliche Lastbedingungen herzustellen;
Detektieren von Parameterwerten mindestens eines Lastkennparameters unter unterschiedlichen Lastbedingungen;
**dadurch gekennzeichnet, dass** die Steuerung ferner dazu eingerichtet ist, Folgendes auszuführen:
Berechnen eines Vergleichswerts der Parameterwerte des Lastkennparameters unter unterschiedlichen Lastbedingungen;
Bestimmen, ob der Vergleichswert innerhalb eines vorgegebenen Schwellenwerts liegt; wenn ja, Bestimmen des Vorhandenseins eines Neutralleiters; wenn nein, Bestimmen des Fehlens des Neutralleiters.

2. Die Neutralleiterdetektionsschaltung (100) nach Anspruch 1, wobei die Kapazitäten der drei ersten Kondensatoren (30: C₁, C₂, C₃) gleich sind, die Kapazitäten der drei zweiten Kondensatoren (40: C₄, C₅, C₆) ungleich sind, und das Ändern eines Zustands des mindestens einen Schalters zum Herstellen unterschiedlicher Lastbedingungen umfasst:
Ausschalten der drei Schalter (20: S₁, S₂, S₃), um eine dreiphasige symmetrische Lastbedingung herzustellen; und
Einschalten des mindestens einen Schalters, um eine dreiphasige asymmetrische Lastbedingung herzustellen.

3. Die Neutralleiterdetektionsschaltung (100) nach Anspruch 1, wobei die Kapazitäten der drei ersten Kondensatoren (30: C₁, C₂, C₃) gleich sind, die Kapazitäten der drei zweiten Kondensatoren (40: C₄, C₅, C₆) gleich sind, und das Ändern eines Zustands des mindestens einen Schalters zum Herstellen unterschiedlicher Lastbedingungen umfasst:
Ausschalten der drei Schalter (20: S₁, S₂, S₃) oder Einschalten der drei Schalter (20: S₁, S₂, S₃), um eine dreiphasige symmetrische Lastbedingung herzustellen; und
Einschalten eines oder zweier Schalter, um eine dreiphasige asymmetrische Lastbedingung herzustellen.

4. Die Neutralleiterdetektionsschaltung (100) nach Anspruch 1, wobei die Kapazitäten der drei ersten Kondensatoren (30: C₁, C₂, C₃) ungleich sind, und das Ändern eines Zustands des mindestens einen Schalters zum Herstellen unterschiedlicher Lastbedingungen umfasst:
Einschalten des mindestens einen Schalters, sodass die Lastbedingung von einer ersten dreiphasigen asymmetrischen Lastbedingung in eine zweite dreiphasige asymmetrische Lastbedingung geändert wird.

5. Die Neutralleiterdetektionsschaltung (100) nach einem der Ansprüche 2 bis 4, wobei das Berechnen eines Vergleichswerts der Parameterwerte des Lastkennparameters unter unterschiedlichen Lastbedingungen umfasst:
Berechnen des Vergleichswerts mittels eines Subtraktions- oder Divisionsverfahrens.

6. Die Neutralleiterdetektionsschaltung (100) nach Anspruch 5, wobei der Lastkennparameter eine Lastphasenspannung umfasst, die Parameterwerte der Lastphasenspannung des Phasenzweigs, bei dem der Zustand des Schalters zwischen Ein- und Ausschalten umgeschaltet wird, eine erste Spannung V1 beziehungsweise eine zweite Spannung V2 sind, bei der Berechnung des Vergleichswerts der Parameterwerte mittels des Subtraktionsverfahrens der vorgegebene Schwellenwert als a*V1 definiert ist, und wenn die Bedingung |V1-V2|>a*V1 erfüllt ist, das Fehlen des Neutralleiters bestimmt wird; andernfalls wird das Vorhandensein des Neutralleiters bestimmt.

7. Die Neutralleiterdetektionsschaltung (100) nach Anspruch 5, wobei der Lastkennparameter eine Lastphasenspannung umfasst, die Parameterwerte der Lastphasenspannung des Phasenzweigs, bei dem der Zustand des Schalters zwischen Ein- und Ausschalten umgeschaltet wird, eine erste Spannung V1 beziehungsweise eine zweite Spannung V2 sind, bei der Berechnung des Vergleichswerts der Parameterwerte mittels des Divisionsverfahrens der vorgegebene Schwellenwert als b definiert ist, und wenn die Bedingung V1/V2>b erfüllt ist, das Fehlen des Neutralleiters bestimmt wird; andernfalls wird das Vorhandensein des Neutralleiters bestimmt.

8. Die Neutralleiterdetektionsschaltung (100) nach Anspruch 1, wobei die Neutralleiterdetektionsschaltung ferner umfasst:
einen dreiphasigen leistungselektronischen Umrichter (50), der elektrisch mit den drei Phasenzweigen (11) des Dreiphasenschaltkreises (10) verbunden ist, wobei in dem Dreiphasenschaltkreis (10) ein EMI-Filter konfiguriert ist, und die drei ersten Kondensatoren (30: C₁, C₂, C₃) sowie die drei zweiten Kondensatoren (40: C₄, C₅, C₆) X-Kondensatoren des EMI-Filters sind, die jeweils in den entsprechenden Phasenzweigen (11) elektrisch mit dem Lastneutralpunkt (N) verbunden sind.

9. Ein Neutralleiterdetektionsverfahren (200), angewendet auf einen Dreiphasenschaltkreis (10), wobei der Dreiphasenschaltkreis (10) drei Schalter (20: S₁, S₂, S₃), die jeweils in Reihe mit den entsprechenden Phasenzweigen (11) des Dreiphasenschaltkreises (10) verbunden sind, drei erste Kondensatoren (30: C₁, C₂, C₃), die zwischen einem Lastneutralpunkt (N) des Dreiphasenschaltkreises (10) und erstseitigen Knoten (A, B, C) der verbundenen Schalter (20: S₁, S₂, S₃) verbunden sind, sowie drei zweite Kondensatoren (40: C₄, C₅, C₆), die zwischen dem Lastneutralpunkt (N) und zweitseitigen Knoten (A', B', C') der jeweiligen Schalter (20: S₁, S₂, S₃) verbunden sind, umfasst, wobei das Neutralleiterdetektionsverfahren umfasst:
Ändern eines Zustands des mindestens einen Schalters, um unterschiedliche Lastbedingungen herzustellen;
Detektieren von Parameterwerten mindestens eines Lastkennparameters unter unterschiedlichen Lastbedingungen;
**dadurch gekennzeichnet, dass** das Verfahren ferner umfasst:
Berechnen eines Vergleichswerts der Parameterwerte des Lastkennparameters unter unterschiedlichen Lastbedingungen;
Bestimmen, ob der Vergleichswert innerhalb eines vorgegebenen Schwellenwerts liegt; wenn ja, Bestimmen des Vorhandenseins eines Neutralleiters; wenn nein, Bestimmen des Fehlens des Neutralleiters.

10. Das Neutralleiterdetektionsverfahren (200) nach Anspruch 9, wobei die Kapazitäten der drei ersten Kondensatoren (30: C₁, C₂, C₃) gleich sind, die Kapazitäten der drei zweiten Kondensatoren (40: C₄, C₅, C₆) ungleich sind, und das Ändern eines Zustands des mindestens einen Schalters zum Herstellen unterschiedlicher Lastbedingungen umfasst:
Ausschalten der drei Schalter, um eine dreiphasige symmetrische Lastbedingung herzustellen; und
Einschalten des mindestens einen Schalters, um eine dreiphasige asymmetrische Lastbedingung herzustellen.

11. Das Neutralleiterdetektionsverfahren (200) nach Anspruch 9, wobei die Kapazitäten der drei ersten Kondensatoren (30: C₁, C₂, C₃) gleich sind, die Kapazitäten der drei zweiten Kondensatoren (40: C₄, C₅, C₆) gleich sind, und das Ändern eines Zustands des mindestens einen Schalters zum Herstellen unterschiedlicher Lastbedingungen umfasst:
Ausschalten der drei Schalter oder Einschalten der drei Schalter, um eine dreiphasige symmetrische Lastbedingung herzustellen; und
Einschalten eines oder zweier Schalter, um eine dreiphasige asymmetrische Lastbedingung herzustellen.

12. Das Neutralleiterdetektionsverfahren (200) nach Anspruch 9, wobei die Kapazitäten der drei ersten Kondensatoren (30: C₁, C₂, C₃) ungleich sind, und das Ändern eines Zustands des mindestens einen Schalters zum Herstellen unterschiedlicher Lastbedingungen umfasst:
Einschalten des mindestens einen Schalters, sodass die Lastbedingung von einer ersten dreiphasigen asymmetrischen Lastbedingung in eine zweite dreiphasige asymmetrische Lastbedingung geändert wird.

13. Das Neutralleiterdetektionsverfahren (200) nach einem der Ansprüche 10 bis 12, wobei das Berechnen eines Vergleichswerts der Parameterwerte des Lastkennparameters unter unterschiedlichen Lastbedingungen umfasst:
Berechnen des Vergleichswerts mittels eines Subtraktions- oder Divisionsverfahrens.

14. Das Neutralleiterdetektionsverfahren (200) nach Anspruch 13, wobei der Lastkennparameter eine Lastphasenspannung umfasst, die Parameterwerte der Lastphasenspannung des Phasenzweigs, bei dem der Zustand des Schalters zwischen Ein- und Ausschalten umgeschaltet wird, eine erste Spannung V1 beziehungsweise eine zweite Spannung V2 sind, bei der Berechnung des Vergleichswerts der Parameterwerte mittels des Subtraktionsverfahrens der vorgegebene Schwellenwert als a*V1 definiert ist, und wenn die Bedingung |V1-V2|>a*V1 erfüllt ist, das Fehlen des Neutralleiters bestimmt wird; andernfalls wird das Vorhandensein des Neutralleiters bestimmt.

15. Das Neutralleiterdetektionsverfahren (200) nach Anspruch 13, wobei der Lastkennparameter eine Lastphasenspannung umfasst, die Parameterwerte der Lastphasenspannung des Phasenzweigs, bei dem der Zustand des Schalters zwischen Ein- und Ausschalten umgeschaltet wird, eine erste Spannung V1 beziehungsweise eine zweite Spannung V2 sind, bei der Berechnung des Vergleichswerts der Parameterwerte mittels des Divisionsverfahrens der vorgegebene Schwellenwert als b definiert ist, und wenn die Bedingung V1/V2 > b erfüllt ist, das Fehlen des Neutralleiters bestimmt wird; andernfalls wird das Vorhandensein des Neutralleiters bestimmt.

## Revendications

1. Circuit de détection de ligne neutre (100) pour un circuit triphasé (10) présentant un point neutre de charge (N), le circuit de détection de ligne neutre (100) comprenant
trois commutateurs (20 : S₁, S₂, S₃) conçus pour être raccordés en série à des branches de phase (11) respectives du circuit triphasé (10),
trois premiers condensateurs (30 : C₁, C₂, C₃) raccordés entre le point neutre de charge (N) et des premiers nœuds latéraux (A, B, C) des commutateurs (20 : S₁, S₂, S₃) respectifs,
trois deuxièmes condensateurs (40 : C₄, C₅, C₆) raccordés entre le point neutre de charge (N) et trois deuxièmes nœuds latéraux (A', B', C') des commutateurs (20 : S₁, S₂, S₃) respectifs,
un dispositif de commande conçu pour exécuter :
un changement d'état de l'au moins un commutateur pour établir différentes conditions de charge,
la détection de valeurs d'au moins un paramètre caractéristique de charge sous différentes conditions de charge ;
**caractérisé en ce que** le dispositif de commande est en outre conçu pour exécuter :
le calcul d'une valeur de comparaison des valeurs du paramètre caractéristique de charge sous différentes conditions de charge,
la détermination du fait que la valeur de comparaison se situe ou non dans des limites d'un seuil spécifié ; si c'est le cas, la détermination de la présence d'une ligne neutre ; sinon, la détermination de l'absence de ligne neutre.

2. Circuit de détection de ligne neutre (100) selon la revendication 1, dans lequel les capacités des trois premiers condensateurs (30 : C₁, C₂, C₃) sont égales, les capacités des trois deuxièmes condensateurs (40 : C₄, C₅, C₆) ne sont pas égales, et le changement d'état de l'au moins un commutateur pour établir différentes conditions de charge comprend :
la mise hors tension des trois commutateurs (20 : S₁, S₂, S₃) pour établir une condition de charge triphasée symétrique, et
la mise sous tension de l'au moins un commutateur pour établir une condition de charge triphasée asymétrique.

3. Circuit de détection de ligne neutre (100) selon la revendication 1, dans lequel les capacités des trois premiers condensateurs (30 : C₁, C₂, C₃) sont égales, les capacités des trois deuxièmes condensateurs (40 : C₄, C₅, C₆) sont égales, et le changement d'état de l'au moins un commutateur pour établir différentes conditions de charge comprend :
la mise hors tension des trois commutateurs (20 : S₁, S₂, S₃) ou la mise sous tension des trois commutateurs (20 : S₁, S₂, S₃) pour établir une condition de charge triphasée symétrique, et
la mise sous tension d'un ou deux commutateurs pour établir une condition de charge triphasée asymétrique.

4. Circuit de détection de ligne neutre (100) selon la revendication 1, dans lequel les capacités des trois premiers condensateurs (30 : C₁, C₂, C₃) ne sont pas égales, et le changement d'état de l'au moins un commutateur pour établir différentes conditions de charge comprend :
la mise sous tension de l'au moins un commutateur de façon que la condition de charge passe de la première condition de charge triphasée asymétrique à la deuxième condition de charge triphasée asymétrique.

5. Circuit de détection de ligne neutre (100) selon l'une quelconque des revendications 2 à 4, dans lequel le calcul d'une valeur de comparaison des valeurs du paramètre caractéristique de charge sous différentes conditions de charge comprend :
le calcul de la valeur de comparaison grâce à une méthode de soustraction ou de division.

6. Circuit de détection de ligne neutre (100) selon la revendication 5, dans lequel le paramètre caractéristique de charge comprend une tension de phase de charge, les valeurs de paramètre de la tension de phase de charge de la branche de phase vers laquelle l'état du commutateur bascule entre la mise sous tension et la mise hors tension sont respectivement une première tension V1 et une deuxième tension V2 ; lors du calcul de la valeur de comparaison des valeurs de paramètre par la méthode de soustraction, le seuil spécifié est défini comme a*V1, et lorsque la condition |V1-V2| > a*V1 est satisfaite, l'absence de la ligne neutre est déterminée et dans le cas contraire la présence de la ligne neutre est déterminée.

7. Circuit de détection de ligne neutre (100) selon la revendication 5, dans lequel le paramètre caractéristique de charge comprend une tension de phase de charge, les valeurs de paramètre de la tension de phase de charge de la branche de phase vers laquelle l'état du commutateur bascule entre la mise sous tension et la mise hors tension sont respectivement une première tension V1 et une deuxième tension V2 ; lors du calcul de la valeur de comparaison des valeurs de paramètre par la méthode de division, le seuil spécifié est défini comme b, et lorsque la condition V1/V2 > b est satisfaite, l'absence de la ligne neutre est déterminée et dans le cas contraire la présence de la ligne neutre est déterminée.

8. Circuit de détection de ligne neutre (100) selon la revendication 1, le circuit de détection de ligne neutre comprenant en outre :
un convertisseur électronique de puissance triphasé (50) raccordé électriquement aux trois branches de phase (11) du circuit triphasé (10), un filtre EMI étant configuré dans le circuit triphasé (10), et les trois premiers condensateurs (30 : C₁, C₂, C₃) et les trois deuxièmes condensateurs (40 : C₄, C₅, C₆) étant des condensateurs X du filtre EMI, chacun raccordé électriquement au point neutre de charge (N) dans les branches de phase (11) respectives.

9. Procédé de détection de ligne neutre (200) appliqué à un circuit triphasé (10), le circuit triphasé (10) comprenant trois commutateurs (20 : S₁, S₂, S₃) raccordés en série à des branches de phase (11) respectives du circuit triphasé (10), trois premiers condensateurs (30 : C₁, C₂, C₃) raccordés entre un point neutre de charge (N) du circuit triphasé (10) et des premiers nœuds latéraux (A, B, C) des commutateurs (20 : S₁, S₂, S₃) raccordés, et trois deuxièmes condensateurs (40 : C₄, C₅, C₆) raccordés entre le point neutre de charge (N) et des deuxièmes nœuds latéraux (A', B', C') des commutateurs (20 : S₁, S₂, S₃) respectifs, le procédé de détection de ligne neutre comprenant :
un changement d'état de l'au moins un commutateur pour établir différentes conditions de charge,
la détection de valeurs d'au moins un paramètre caractéristique de charge sous différentes conditions de charge,
**caractérisé en ce que** le procédé comprend en outre :
le calcul d'une valeur de comparaison des valeurs du paramètre caractéristique de charge sous différentes conditions de charge,
la détermination du fait que la valeur de comparaison se situe ou non dans les limites d'un seuil spécifié ; si c'est le cas, la détermination de la présence d'une ligne neutre ; sinon, la détermination de l'absence d'une ligne neutre.

10. Procédé de détection de ligne neutre (200) selon la revendication 9, dans lequel les capacités des trois premiers condensateurs (30 : C₁, C₂, C₃) sont égales, les capacités des trois deuxièmes condensateurs (40 : C₄, C₅, C₆) ne sont pas égales, et le changement d'état de l'au moins un commutateur pour établir différentes conditions de charge comprend :
la mise hors tension des trois commutateurs pour établir une condition de charge triphasée symétrique, et
la mise sous tension de l'au moins un commutateur pour établir une condition de charge triphasée asymétrique.

11. Procédé de détection de ligne neutre (200) selon la revendication 9, dans lequel les capacités des trois premiers condensateurs (30 : C₁, C₂, C₃) sont égales, les capacités des trois deuxièmes condensateurs (40 : C₄, C₅, C₆) sont égales, et le changement d'état de l'au moins un commutateur pour établir différentes conditions de charge comprend :
la mise hors tension des trois commutateurs ou la mise sous tension des trois commutateurs pour établir une condition de charge triphasée symétrique, et
la mise sous tension d'un ou deux commutateurs pour établir une condition de charge triphasée asymétrique.

12. Procédé de détection de ligne neutre (200) selon la revendication 9, dans lequel les capacités des trois premiers condensateurs (30 : C₁, C₂, C₃) ne sont pas égales, et le changement d'état de l'au moins un commutateur pour établir différentes conditions de charge comprend :
la mise sous tension de l'au moins un commutateur de façon que la condition de charge passe de la première condition de charge triphasée asymétrique à la deuxième condition de charge triphasée asymétrique.

13. Procédé de détection de ligne neutre (200) selon l'une quelconque des revendications 10 à 12, dans lequel le calcul d'une valeur de comparaison des valeurs du paramètre caractéristique de charge sous différentes conditions de charge comprend :
le calcul de la valeur de comparaison grâce à une méthode de soustraction ou de division.

14. Procédé de détection de ligne neutre (200) selon la revendication 13, dans lequel le paramètre caractéristique de charge comprend une tension de phase de charge, les valeurs de paramètre de la tension de phase de charge de la branche de phase vers laquelle l'état du commutateur bascule entre la mise sous tension et la mise hors tension sont respectivement une première tension V1 et une deuxième tension V2 ; lors du calcul de la valeur de comparaison des valeurs de paramètre par la méthode de soustraction, le seuil spécifié est défini comme a*V1, et lorsque la condition |V1-V2| > a*V1 est satisfaite, l'absence de la ligne neutre est déterminée et dans le cas contraire la présence de la ligne neutre est déterminée.

15. Procédé de détection de ligne neutre (200) selon la revendication 13, dans lequel le paramètre caractéristique de charge comprend une tension de phase de charge, les valeurs de paramètre de la tension de phase de charge de la branche de phase vers laquelle l'état du commutateur bascule entre la mise sous tension et la mise hors tension sont respectivement une première tension V1 et une deuxième tension V2 ; lors du calcul de la valeur de comparaison des valeurs de paramètre par la méthode de division, le seuil spécifié est défini comme b, et lorsque la condition V1/V2 > b est satisfaite, l'absence de la ligne neutre est déterminée et dans le cas contraire la présence de la ligne neutre est déterminée.
